# EUROPEAN PATENT APPLICATION

(11) **EP 1 094 694 A1**
(43) Date of publication of application: **25.04.2001**
(21) Application number: 00911314.3
(22) Date of filing: 23.03.2000
(51) Int. Cl.: H05K 3/46

(54) **METHOD OF MANUFACTURING METHOD OF CERAMIC MULTILAYER BOARD**

(30) Priority: 15.04.1999 JP 10841699
(71) Applicant: Matsushita Electric Industrial Co., Ltd., Kadoma-shi, Osaka 571-8501 (JP)
(72) Inventor: SEGAWA, Shigetoshi, Niihama-shi, Ehime 792-0050 (JP); OCHI, Hiroshi, Saijo-shi, Ehime 793-0043 (JP)
(74) Representative: Kügele, Bernhard
(86) International application number: JP0001783
(87) International publication number: WO0064227

(57) **Abstract**

As a result of the disclosure made in the present invention, a multi-layer ceramic substrate with a provision to prevent delaminating and bulging in lamination from occurring is allowed to be realized. The present invention discloses a manufacturing method of multilayer ceramic substrates comprising the steps of applying a pressing force to a ceramic green sheet laminate with a through hole formed therein and an exterior sheet disposed on both surfaces of the laminate, respectively, and firing the resulting pressed laminate. The exterior sheet has a connecting channel leading to the through hole. When a pressing force is applied to the laminate, air existing in the through hole is let out to outside via the connecting channel.

## Description

### Technical Field

The present invention relates to a manufacturing method of multi-layer ceramic substrates used in manufacturing high density wiring circuit boards.

### Background Art

The conventional manufacturing method of high density wiring circuit boards comprises the steps of preparing, a plurality of ceramic green sheets, each having a wiring circuit pattern, laminating the foregoing plurality of ceramic green sheets and firing the laminated plurality of ceramic green sheets, thereby producing a multilayer ceramic substrate to form multilayered circuits.

In the steps as described above, there is provided a step of pressing a plurality of ceramic green sheets after the plurality of ceramic green sheets have been overlaid one upon another, thereby allowing the ceramic green sheets to be pressed against one another to have the wiring circuit patterns that are disposed on each respective green sheet surface buried in the respective green sheets. As a result, a solid one-piece structure is established between respective green sheet layers after the firing step of the multilayer ceramic substrate.

Each respective multilayer ceramic substrate may be sometimes provided with such through holes as bolt holes for mounting the wiring circuit board on another wiring circuit board or on an electronic component, via-holes for mounting other components thereon and the like.

In order to facilitate handling of the laminated ceramic green sheets, a protective film formed of a synthetic resin is adhered on both surfaces of the ceramic green sheet laminate.

Further, in the step of firing, a thermal deformation preventing sheet is disposed on both surfaces of the ceramic green sheet laminate to prevent the ceramic green sheet laminate from shrinking by heat. When the ceramic green sheet is formed of glass ceramic, an alumina sheet and the like are used as the thermal deformation preventing sheet.

In the manufacturing method of multilayer ceramic substrates as described in above, when there are provided through holes on a ceramic green sheet laminate, the multilayer ceramic substrates manufactured are liable to possible defects such as layer peeling, layer bulging and the like.

A cause of the foregoing is speculated as follows: When a plurality of ceramic green sheets are pressed and there are no escapes provided for air existing in through holes, part of the air gets in the gaps between ceramic green sheets, resulting in peeling of the ceramic green sheets from one another or bulging of the ceramic green sheets therebetween. More specifically, since a protective film or thermal deformation preventing sheet is disposed on both surfaces of the green sheet laminate, there is no escape for the air in the through holes to outside.

This invention discloses a manufacturing method of multilayer ceramic substrates to prevent peeling or bulging of respective layers from occurring.

### Summary of the Invention

A manufacturing method of multilayer ceramic substrates according to the present invention comprises the steps of:
(a) feeding ceramic green sheet laminates;
(b) disposing an exterior sheet on each respective surface of the ceramic green sheet laminate;
(c) applying a pressing force to the exterior sheet clad ceramic green sheet laminate from the side of the laminate' ssurface where a connecting channel is situated; and
(d) firing the pressed green sheet laminate formed in the pressing force application step,
   wherein the ceramic green sheet laminate comprises a plurality of ceramic green sheets;
   wherein the ceramic green sheet laminate has a through hole; and
   wherein the exterior sheet is provided with a connecting channel that leads to the through hole.

It is particularly preferred that the step of applying a pressing force to the exterior sheet clad ceramic green sheet laminate includes the step of letting out the air existing in the through hole to the outside of the exterior sheet via the connecting channel when the ceramic green sheets are laminated.

It is particularly preferred that the exterior sheet material comprises a protective film formed of a synthetic resin.

It is particularly preferred that the exterior sheet material comprises a thermal deformation preventing sheet to prevent the pressed green sheet laminate from undergoing a thermal deformation at the time of firing.

It is particularly preferred that at least one sheet of the plurality of ceramic green sheets has a wiring circuit disposed on the surface thereof.

It is particularly preferred that the through hole has at least one configuration selected from (i) a configuration running through the ceramic green sheet laminate and (ii) a configuration forming an opening on one of the surfaces of the ceramic green sheet laminate.

According to the structures as described in above, peeling and bulging between respective sheets of a plurality of ceramic green sheets are prevented from occurring.

### Brief Description of Drawings

Fig. 1 is a cross-sectional view of the ceramic green sheet laminate as referred to in a manufacturing method of multilayer ceramic substrates in an exemplary embodiment of the present invention.
Fig. 2 is a cross-sectional view of a work condition of the pressing force application step as referred to in the manufacturing method of multi-layer ceramic substrates in the exemplary embodiment of the present invention.
Fig. 3 is a process chart of the manufacturing method of multilayer ceramic substrates in the exemplary embodiment of the present invention.

### Preferred Embodiments of the Invention

A manufacturing method of multilayer ceramic substrates in an exemplary embodiment of the present invention comprises the steps of:
laminating a plurality of ceramic green sheets with an exterior sheet disposed on both surfaces of each respective ceramic green sheet;
applying a pressing force to the laminated ceramic green sheets; and
firing the pressed plurality of ceramic green sheets.
The ceramic green sheet laminate has a through hole.

The manufacturing method of the present exemplary embodiment further comprises the step of forming a connecting channel to connect the through hole formed in the laminate prepared according to the laminating step to the outer surface of the exterior sheet material.

Next, a description is given to each of the structural elements, work steps and the like.

### (A) Ceramic Green Sheet:

As the ceramic green sheet for the embodiments of the present invention, a ceramic green sheet used in manufacturing an ordinary multilayer ceramic substrate can be used. As the ceramic material, alumina, glass ceramics and the like are used, for example.

A ceramic green sheet is formed of a ceramic powder and a binder. The ceramic powder is dispersed in the liquefied or viscous binder. A mixture comprising the ceramic powder and binder is formed into a sheet-like shape to produce a ceramic green sheet.

On the surface of the ceramic green sheet is provided a wiring circuit pattern as needed. An ordinary circuit forming technology such as a printing method and the like is employed as the production method of the wiring circuit pattern. The wiring circuit pattern includes such functional parts as a conductor circuit, resistor, capacitor and the like.

The number of the ceramic green sheets to be laminated is allowed to be determined as needs require, ranging from several sheets to several tens of sheets, for example.

### (B) Through Hole:

A through hole is formed in the steps before the step of applying a pressing force to laminated ceramic green sheets. The position and configuration of the through hole are determined as necessary to suit the application and required performance of the multilayer ceramic substrate as desired. A through hole is intended for having a fastening fixture such as a bolt and the like inserted therein and holding some other components, for example, and therefore the position and configuration of the through hole need to be determined according to these requirements of usage.

A through hole is formed, for example, by applying drilling work to a predetermined number of green sheets that are superimposed one over another. Also, a through hole can be formed in such a way that each respective ceramic green sheet is provided with a through hole formed by a punch press and then a predetermined number of the punched ceramic green sheets are superimposed one over another.

A through hole runs through laminated ceramic green sheets or an opening of the through hole exists only on one surface of the laminated ceramic green sheets or no openings of the through hole appear on the surfaces of the laminated ceramic green sheets by just being formed inside thereof. This ceramic green sheet laminate having a through hole just inside thereof is prepared by a method of superimposing ceramic green sheets, each having a through hole, and ceramic green sheets having no through holes one over another. In this case, there is provided a connecting channel that extends from the through hole formed inside of the ceramic green sheet laminate to as far as the surface thereof, thereby allowing the air existing in the through hole formed inside of the ceramic green sheet laminate to be let out to the outside thereof.

Further, a ceramic green sheet sometimes has a small hole called via-hole. In general, a conductive material is filled inside of the via-hole and there is little chance for air to stay inside of the via-hole. Therefore, the via-hole as such is not included in what is referred to as a through hole in the present invention.

### (C) Exterior Sheet Material:

An exterior sheet material belongs to a sheet material. In the step of a pressing force application, the exterior sheet material is disposed on both surfaces of a ceramic green sheet laminate, respectively. The exterior sheet material is provided with a connecting channel that leads to the external surface of the ceramic green sheet laminate at the position where the through hole is located, thereby leaving the opening of the through hole uncovered.

A protective film is used as the exterior sheet material, for example. When a ceramic green sheet laminate is transferred from the laminating step to the step of a pressing force application or is stored temporarily, the protective film is used to protect the relatively soft ceramic green sheets. The protective film is formed of synthetic resins such as polyethyleneterephthalate (PET), polyphenylsulfide (PPS) and the like, for example.

A thermal deformation preventing sheet is also used as the exterior sheet material, for example. The thermal deformation preventing sheet is a sheet material having the function of preventing an excessive thermal deformation from taking place with ceramic green sheets when a ceramic green sheet laminate is fired. As the thermal deformation preventing sheet is used such a material as showing a low thermal expansion coefficient in comparison with the green sheet in the firing temperature range of the ceramic green sheet laminate. When a ceramic green sheet containing glass ceramics to be fired at a relatively low temperature is used, for example, a sheet containing alumina that hardly causes thermal expansion in the firing temperature range of the glass ceramics can be used as the thermal deformation preventing sheet. The thermal deformation preventing sheet is eliminated by peeling off from the multilayer ceramic substrate after the firing step.

Also employed is such a structure as having a thermal deformation preventing sheet disposed on both surfaces of the ceramic green sheet laminate, respectively, and having a protective film disposed on the outer surface of the thermal deformation preventing sheet.

### (D) Connecting Channel:

With a laminate formed of a plurality of ceramic green sheets superimposed one over another and exterior sheet materials, a connecting channel is formed so as to connect a through hole provided in the ceramic green sheet laminate to the outer surface of each respective exterior sheet material.

The connecting channel is a through hole formed in the exterior sheet material and the through hole is located at the same position as the opening of the through hole of the ceramic green sheet laminate is located on the surface of the ceramic green sheet laminate. The size of the through hole formed in the exterior sheet material needs to be large enough to let the air in the through hole of the ceramic green sheet laminate escape to outside. As the size of the through hole in the exterior sheet material, for example, can be used almost the same size as the through hole in the ceramic green sheet laminate or as the diameter of the through hole in the exterior sheet material can be used a smaller diameter than the diameter of the through hole in the ceramic green sheet laminate. The same step as employed in forming the through hole in the ceramic green sheet laminate can be used under the condition where the ceramic green sheet laminate and exterior sheet material are put together by lamination, thereby allowing the through hole in the ceramic green sheet laminate and through hole in the exterior sheet material to be formed at the same time.

As the exterior sheet material can be used a sheet material with air permeability. In this case, the entire surface of the exterior sheet material performs the function of the connecting channel.

### (E) Pressing Force Application Step:

A pressing force application step is performed under the condition where a ceramic green sheet laminate having a through hole and an exterior sheet material having a connecting channel are superimposed one over the other.

In the pressing force application step, an ordinary press machine is used. At the same time as the laminate is applied with a pressing force, the laminate is heated.

Also, in the pressing force application step, the ceramic green sheet laminate and exterior sheet material are pressed against each other, resulting in a shrinkage in the longitudinal direction, accompanied with a reduction in the length of the through hole. Accordingly, the air inside of the through hole is escaping to outside from the surface of the exterior sheet material via the connecting channel. When the application of a pressing force and heating take place at the same time, the volume of the air inside of the through hole increases due to thermal expansion with a resulting escape of the expanded air to outside via the connecting channel of the exterior sheet material. However, due to the pressing force applied to the surface of the exterior sheet material via the pressing table of a press machine, the air existing in the through hole is prevented from escaping to outside at this particular stage. As soon as the pressing force application step is finished and the pressing force is reduced, or the pressing table is detached from the surface of the exterior sheet material, the air inside of the through hole is released to outside via the connecting channel of the exterior sheet material, thereby allowing such defects as infiltration of air in gaps between ceramic green sheets and peeling of sheets away from one another to be prevented from occurring.

Particularly preferred is the step of leaving the green sheet laminate standing alone to be put in place after the pressing force application step is over and before the firing step starts. The ceramic green sheet laminate is not yet hardened at the stage when the curing and pressing force application step is finished. Therefore, there still remains a possibility for the ceramic green sheet pressed laminate to be deformed, thereby allowing the distortion and stress created inside of the laminate at the pressing force application step to be eliminated during the step of leaving the green sheet laminate standing alone before the next firing step starts. As a result, the minute peeling off and distortion created between and in the ceramic green sheets, respectively, disappear as the time in the step of leaving the green sheet laminate standing alone elapses. Thus, the minute peeling off and distortion of the ceramic green sheets left behind by the pressing force application step can also be eliminated.

### (F) Firing Step:

The firing conditions for the firing step such as firing temperatures, firing time and the like are set up based on the materials and required performance of the ceramic green sheets.

When a thermal deformation preventing sheet is used as the exterior sheet material, the thermal deformation preventing sheet suppresses a thermal shrinkage of ceramic green sheets that takes place at the firing step. When a protective film is used as the exterior sheet material, the protective film is removed before the firing step.

A multilayer ceramic substrate obtained at the end of the firing step undergoes a post-processing step as necessary. As the post-processing step, there are, for example, such steps as forming a wiring circuit pattern on the surface of the multilayer ceramic substrate, mounting electronic elements on the multilayer ceramic substrate, putting the multilayer ceramic substrate together with a separate electronic component and the like.

Next, a description is given to some of the exemplary embodiments of the present invention.

### First Exemplary Embodiment

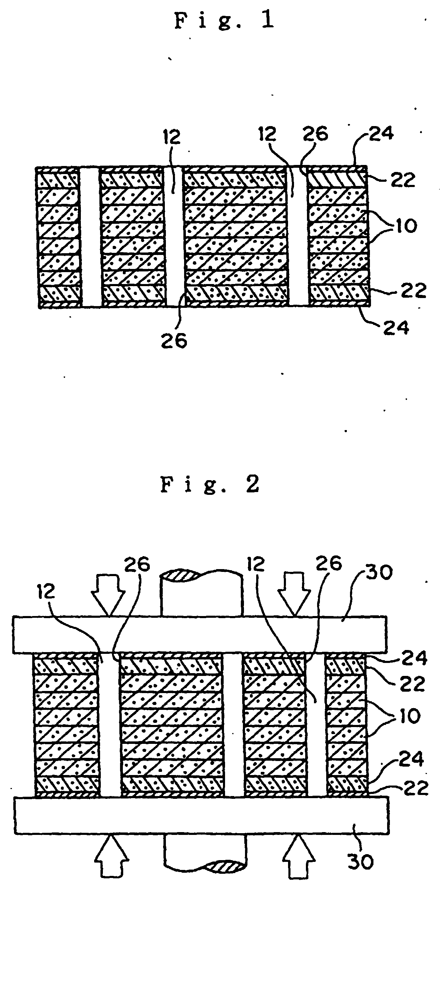

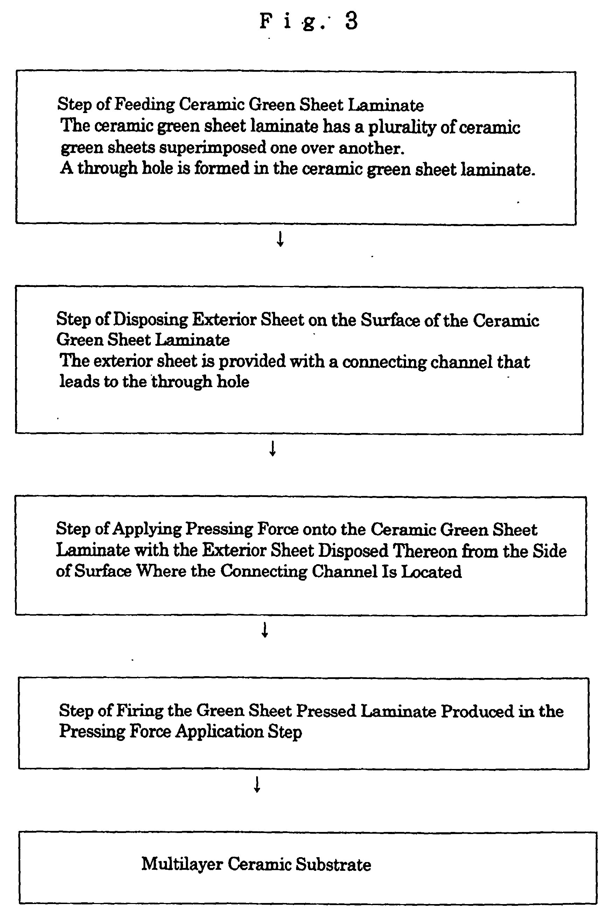

Fig. 1 is a cross-sectional view of a multilayer ceramic substrate manufactured of a plurality of ceramic green sheets. Fig. 2 shows a method for applying a pressing force to a laminate formed of a plurality of ceramic green sheets. Fig. 3 is a process chart to show a manufacturing method of multilayer ceramic substrates.

A ceramic green sheet 10 has the geometry of a sheet. The ceramic green sheet 10 comprises a glass ceramic powder and a binder. The ceramic powder is dispersed in the binder. A wiring circuit pattern is disposed on the surface of the ceramic green sheet 10. The wiring circuit pattern is not shown in the drawings. The wiring circuit pattern is disposed on the surface of a ceramic green sheet 10 by such methods as a conductive material printing method and the like.

A plurality of ceramic green sheets 10, thermal deformation preventing sheets 22 and protective sheets 24 are put together by lamination. The thermal deformation preventing sheet 22 is disposed on each respective surface of the ceramic green sheet 10. In addition, the protective film 24 is disposed on each respective outer surface of the thermal deformation preventing sheet 22. The thermal deformation preventing sheet 22 is formed of an alumina sheet. The protective film 24 is formed of a PET film.

A through hole 12 is formed at a plurality of places of the laminate of ceramic green sheets 10 in such a way as running through both surfaces of each respective green sheet 10. A connecting channel 26 is formed in the thermal deformation preventing sheet 22 and protective film 24 at such positions as leading to the through hole 12.

More specifically, when a plurality of the ceramic green sheets 10, thermal deformation preventing sheets 22 and protective films 24 are put together to form a laminate, the through hole 12 and connecting channel 26 are formed at the same time by applying a drilling process to the laminate.

Fig. 2 shows the process of applying a pressing force to the laminate. The laminate formed of the ceramic green sheets 10, thermal deformation preventing sheets 22 and protective films 24 is placed between a pair of pressing tables 30 of a press work machine and applied with a pressing force via the pair of pressing tables 30, thereby having the ceramic green sheets 10 pressed against one another to complete single-piece construction. As a result, an integrally-formed ceramic green sheet pressed laminate is produced. At this time, the wiring circuit pattern formed on the surface of each respective green sheet 10 ends up being buried in the green sheet 10. Accordingly, after the pressing force application step, the total thickness of the laminated ceramic green sheets 10 is reduced than before. In addition, the air contained inside of the through hole 12 is compressed in volume. A portion of the air is let out to outside through the gaps between the pressing table 30 and the protective film 24. Another portion of the air works toward expanding the through hole 12 and deforming the ceramic green sheet 10, or gets into the gaps between the ceramic green sheets 10.

Upon finishing the application of a pressing force to the laminate, the pressed laminate of the ceramic green sheets 10 formed by the pressing force application is left standing as is with the applied pressing force removed. During the foregoing step of leaving the laminate standing as is, the stress and distortion created during the pressing force application step are gradually removed as time elapses. During the period of this step, a little distortion created in the vicinity of the through hole 12 by the compressed air contained in the through hole 12 and the peeling of the green sheets 10 from one another are allowed to be recovered.

Then, the protective film 24 is peeled off and the resultant pressed laminate is fired under a predetermined condition, thereby finishing the manufacture of a multilayer ceramic substrate.

### Second Exemplary Embodiment

A multilayer ceramic substrate in an exemplary embodiment of the present invention is produced and the performance thereof is evaluated.

By the use of a punching process, via-holes and through holes for insertion of components are formed on each respective glass ceramic green sheet. These holes are piercing through both surfaces of the glass ceramic green sheet. The inner diameter of the via-holes ranges from around 0.1 mm to 0.3 mm while the inner diameter of the through holes for insertion of components ranging from around 0.3 mm to 2.5 mm. The via-holes are filled with a conductive paste. On the surface of each respective glass ceramic green sheet is formed a predetermined wiring circuit pattern.

Thus, a variety of green sheets, each having a wiring circuit pattern, are prepared and then these green sheets are put together by superimposing one over another. A thermal deformation preventing sheet and a protective film are, respectively, laminated on both surfaces of the green sheet laminate thus obtained. The thermal deformation preventing sheet is formed of a green sheet containing alumina ceramic while the protective film being formed of a PET resin. Through holes are formed by a punching work in advance on the thermal deformation preventing sheet and protective film at the same positions as the positions of the holes for insertion of components formed on the foregoing green sheets.

First, the green sheet laminate with the thermal deformation sheets and protective films put together by lamination is tentatively applied with a pressing force, and then proceeds to the stage of a full-fledged application of a pressing force. Accordingly, the green sheet laminate attached with the thermal deformation sheets and protective films goes through the tentative pressing force application step and then the full-fledged pressing force application step where the pressing force is higher than that in the tentative pressing force application step. The protective films are removed during the period between the end of the full-fledged pressing force application step and the firing step following thereafter, thereby obtaining a pressed laminate with the entirety thereof made into single-piece construction.

The pressed laminate thus obtained is fired under a predetermined condition.

Thus, a multilayer ceramic substrate is produced.

In order to make a comparative study, a multilayer ceramic substrate formed of a thermal deformation preventing sheet and protective film with no through holes provided is prepared according to the same method as in the foregoing exemplary embodiment to serve as a control example.

The quality of the multilayer ceramic substrates as prepared in above is evaluated. The result of the evaluation is given in Table 1.

The quality evaluation is performed by observing the cross-section of the multilayer ceramic substrates obtained in above. More specifically, the number of defects per 100 holes for insertion of components is counted. In practice, the number of occasions, where a delaminating phenomenon occurs, is counted and treated as the number of defects.

**Table 1**

| | Exemplary Embodiment | Control Example |
|---|---|---|
| Number of Defects | 0/100 | 25/100 |

As clearly seen in Table 1, the number of defects of the multilayer ceramic substrates obtained in the present exemplary embodiment is "0" while the number of defects of one hundred multilayer ceramic substrates prepared as the control example counting "25", thereby allowing the fact that the manufacturing method of multilayer ceramic substrates of the present invention can prevent the ceramic layers from delaminating to be confirmed.

Thus, with the provision of a step of applying a pressing force to a green sheet laminate while having through holes of each respective green sheet connected to outside, the delaminating defects of multilayer ceramic substrates can be successfully prevented from occurring.

### Industrial Usability

The manufacturing method of multilayer ceramic substrates of the present invention can prevent delaminating and bulging of ceramic layers in multilayer ceramic substrates due to the air existing in through holes of ceramic green sheets from occurring by having connecting channels provided in exterior sheet materials.

### Key to Reference Numerals

- 10: Ceramic Green Sheet
- 12: Through Hole
- 22: Thermal Deformation Preventing Sheet
- 24: Protective Film
- 26: Connecting Channel
- 30: Pressing Table

## Claims

1. A manufacturing method of a multilayer ceramic substrate comprising steps of:
(a) feeding a ceramic green sheet laminate,
wherein said ceramic green sheet laminate formed of a plurality of ceramic green sheets that are superimposed one over another, and
wherein said ceramic green sheet laminate has a through hole;
(b) disposing an exterior sheet on a surface of said ceramic green sheet laminate,
wherein said exterior sheet has a connecting channel to lead to said through hole;
(c) applying a pressing force to said ceramic green sheet laminate with said exterior sheet disposed thereon from a side of said surface having said connecting channel; and
(d) firing said green sheet pressed laminate produced by said pressing force application step.

2. The manufacturing method of a multilayer ceramic substrate according to Claim 1,
wherein a material of said exterior sheet comprises a protective film formed of a synthetic resin.

3. The manufacturing method of a multilayer ceramic substrate according to Claim 1,
wherein said material of said exterior sheet has a deformation preventing sheet to prevent a thermal deformation from occurring when said green sheet pressed laminate is fired.

4. The manufacturing method of a multilayer ceramic substrate according to Claim 1,
wherein at least one ceramic green sheet of said plurality of ceramic green sheets has a wiring circuit pattern disposed on a surface thereof.

5. The manufacturing method of a multilayer ceramic substrate according to Claim 1,
wherein said through hole has at least one configuration selected from configurations of:
(i) running through said ceramic green sheet laminate; and
(ii) opening on a surface of said ceramic green sheet laminate.

6. The manufacturing method of a multilayer ceramic substrate according to Claim 1,
wherein said step of applying a pressing force to said ceramic green sheet laminate with said exterior sheet disposed thereon has a step of letting out air existing in said through hole to outside of said exterior sheet via said connecting channel.

7. The manufacturing method of a multilayer ceramic substrate according to Claim 1,
wherein said exterior sheet comprises an alumina green sheet containing alumina powder, and
said alumina green sheet has a function of preventing a thermal defrmation that occurs when said pressed laminate is fired.

8. The manufacturing method of a multilayer ceramic substrate according to Claim 1,
wherein said step of disposing said exterior sheet comprises steps of:
disposing a thermal deformation preventing sheet on said surface of said ceramic green sheet laminate; and
disposing a protective film on a surface of said thermal deformation preventing sheet,
wherein said thermal deformation preventing sheet has said connecting hole,
wherein said protective film has said connecting channel, and
wherein said step of applying a pressing force to said ceramic green sheet laminate with said exterior sheet disposed thereon comprises a step of letting out air existing in said through hole to outside of said protective film via said connecting channel when said ceramic green sheet laminate is produced.

9. The manufacturing method of a multilayer ceramic substrate according to Claim 1, further comprising a step of removing said protective film from said pressed laminate before said step of firing said green sheet pressed laminate,
wherein said step of disposing said exterior sheet includes the steps of:
disposing a thermal deformation preventing sheet on said surface of said ceramic green sheet laminate; and
disposing a protective film on a surface of said thermal deformation preventing sheet,
wherein said thermal deformation preventing sheet has said connecting channel,
wherein said protective film has said connecting channel, and
wherein said step of applying a pressing force to said ceramic green sheet laminate with said exterior sheet disposed thereon includes a step of letting out air existing in said through hole to outside of said protective film via said connecting channel when said ceramic green sheet laminate is produced.

10. The manufacturing method of a multilayer ceramic substrate according to Claim 1,
wherein said step of feeding a ceramic green sheet laminate has a step of forming said through hole in said ceramic green sheet laminate formed of said plurality of ceramic green sheets.

11. The manufacturing method of a multilayer ceramic substrate according to Claim 1,
wherein said step of feeding a ceramic green sheet laminate includes the steps of:
(I) forming a through hole in each respective ceramic green sheet of said plurality of ceramic green sheets; and
(ii) superimposing respective ceramic green sheets, each having said through hole, one over another so as to have said respective through holes aligned with one another.

12. The manufacturing method of a multilayer ceramic substrate according to Claim 1, further comprising a step of leaving said pressed laminate standing while a pressing force being removed, put in place between said (c) step of applying a pressing force to said ceramic green sheet laminate with said exterior sheet disposed thereon from a side of said surface having said connecting channel and said (d) step of firing said green sheet pressed laminate produced by said pressing force application step.

13. The manufacturing method of a multilayer ceramic substrate according to Claim 1,
wherein said through hole is formed in said ceramic green sheet laminate;
wherein said ceramic green sheet laminate includes a further connecting channel leading from said through hole to said connecting channel; and
wherein said step of applying a pressing force to said ceramic green sheet laminate with said exterior sheet disposed thereon includes a step of letting out air existing in said through hole to out side of said exterior sheet via said further connecting channel and said connecting channel when said ceramic green sheet laminate is produced.

14. The manufacturing method of a multilayer ceramic substrate according to Claim 1,
wherein said through hole acts at least as a hole selected from:
(i) a hole for mounting an electronic component; and
(ii) a hole for inserting a connecting fixture to connect said multilayer ceramic substrate to another component.

15. The manufacturing method of a multilayer ceramic substrate according to Claim 1,
wherein said step of applying a pressing force to said ceramic green sheet laminate with said exterior sheet disposed thereon further includes the steps of:
applying a pressing force to said exterior sheet and ceramic green sheet laminate by pressing a pressing table onto both surfaces, respectively, of said ceramic green sheet laminate with said exterior sheet disposed thereon; and
letting out air existing in said through hole to outside via said connecting channel and a gap formed between said pressing table and said exterior sheet.

16. A manufacturing method of a multilayer ceramic substrate with a provision of preventing a layer from getting delaminated comprising the steps of:
(a) feeding a ceramic green sheet laminate,
wherein said ceramic green sheet laminate formed of a plurality of ceramic green sheets that are superimposed one over another, and
wherein said ceramic green sheet laminate has a through hole;
(b) disposing an exterior sheet on a surface of said ceramic green sheet laminate,
wherein said exterior sheet has a connecting channel to lead to said through hole;
(c) applying a pressing force to said ceramic green sheet laminate with said exterior sheet disposed thereon from a side of said surface having said connecting channel,
wherein air existing in said through hole is let out to outside of said exterior sheet via said connecting channel when a pressing force is applied to said ceramic green sheet laminate; and
(d) fixing said green sheet pressed laminate produced by said pressing force application step.

17. The manufacturing method of a multilayer ceramic substrate according to Claim 16,
wherein said exterior sheet comprises a protective film.

18. The manufacturing method of a multilayer ceramic substrate according to Claim 16,
wherein said exterior sheet has a deformation preventing sheet to prevent a thermal deformation from occurring when said green sheet pressed laminate is fired.

19. The manufacturing method of a multilayer ceramic substrate according to Claim 16,
wherein at least one ceramic green sheet of said plurality of ceramic green sheets has a wiring circuit pattern disposed on a surface thereof.

20. The manufacturing method of a multilayer ceramic substrate according to Claim 16,
wherein said through hole has at least one configuration selected from configurations of:
(i) running through said ceramic green sheet laminate; and
(ii) opening on a surface of said ceramic green sheet laminate.

21. The manufacturing method of a multilayer ceramic substrate according to Claim 16, further comprising a step of removing said protective film from said pressed laminate before said step of firing said green sheet pressed laminate,
wherein said step of disposing said exterior sheet includes the steps of:
disposing a thermal deformation preventing sheet on said surface of said ceramic green sheet laminate; and
disposing a protective film on a surface of said thermal deformation preventing sheet,
wherein said thermal deformation preventing sheet has said connecting channel,
wherein said protective film has said connecting channel, and
wherein said step of applying a pressing force to said ceramic green sheet laminate with said exterior sheet disposed thereon comprises a step of letting out air existing in said through hole to outside of said protective film via said connecting channel when said ceramic green sheet laminate is produced.
